# EUROPEAN PATENT APPLICATION

(11) **EP 1 833 096 A1**
(43) Date of publication of application: **12.09.2007**
(21) Application number: 05814238.1
(22) Date of filing: 09.12.2005
(51) Int. Cl.: H01L 31/04

(54) **CIS-BASED THIN FILM SOLAR BATTERY AND PROCESS FOR PRODUCING THE SAME**

(30) Priority: 09.12.2004 JP 2004356909
(71) Applicant: Showa Shell Sekiyu Kabushiki Kaisha, Minato-ku Tokyo 1358074 (JP)
(72) Inventor: KUSHIYA, Katsumi c/o Showa Shell Sekiyu K.K.,, Tokyo 135-8074 (JP); TANAKA, Yoshiaki c/o Showa Shell Sekiyu K.K.,, Tokyo 135-8074 (JP); ONODERA, Masaru c/o Showa Shell Sekiyu K.K.,, Tokyo 135-8074 (JP); TANAKA, Manabu c/o Showa Shell Sekiyu K.K.,, Tokyo 135-8074 (JP); NAGOYA, Yoshinori c/o Makkari High School,, Hokkaido 048-1611 (JP)
(74) Representative: HOFFMANN EITLE
(86) International application number: PCT/JP2005/022698
(87) International publication number: WO 2006/062206

(57) **Abstract**

An alkali-barrier layer and a metallic back electrode layer are deposited at low cost in a short time and the phenomenon in which a light absorption layer peels off and the metallic back electrode layer is prevented.

The invention relates to: a CIS type thin-film solar cell 1 comprising a glass substrate 2, an alkali-free layer 7, e.g., silica, a multilayered metallic back electrode layer 3, a p-type CIS-based light absorption layer 4, a high-resistance buffer layer 5, and an n-type window layer 6 which have been superposed in this order; and a process for producing the cell. The layer 7 or a combination of it and the first layer 3a of the layer 3 serves as an alkali-barrier layer 8 for preventing and controlling the thermal diffusion of alkali ingredients from the substrate 2 into the light absorption layer during the deposition of the layer 4. The layer 3a comprises crystal grains which are fine and highly dense. The layer 7 is deposited on the substrate by the RF or DC sputtering method and the layer 3 is successively deposited on the layer 7 by the DC sputtering method.

## Description

### TECHNICAL FIELD

The present invention relates to an alkali-barrier layer of a CIS type thin-film solar cell (the alkali-barrier layer, when a light absorption layer is deposited on a metallic back electrode layer, blocks and controls the diffusion of alkali ingredients from the glass substrate underlying the metallic back electrode layer) and to a process for forming the layer.

### BACKGROUND ART

The invention relates to a CIS type thin-film solar cell having a pn heterojunction comprising: a p-type semiconductor such as a thin multinary-compound semiconductor film, in particular, a I-III-VI₂ Group chalcopyrite semiconductor, e.g., copper indium diselenide (CuInSe₂), copper indium gallium diselenide (CuInGaSe₂), copper gallium diselenide (CuGaSe₂), copper indium gallium di-sulfo-sulfide (Cu (InGa) (SSe)₂), copper indium disulfide (CuInS₂), copper gallium disulfide (CuGaS₂), copper indium gallium disulfide (CuInGaS₂), or copper indium gallium diselenide (CuInGaSe₂) having a thin film of copper indium gallium di-sulfo-sulfide (Cu(InGa)(SSe)₂) as a surface layer, as a light absorption layer; a high-resistance buffer layer; and an n-type window layer (transparent conductive film) superposed over the light absorption layer through the buffer layer.

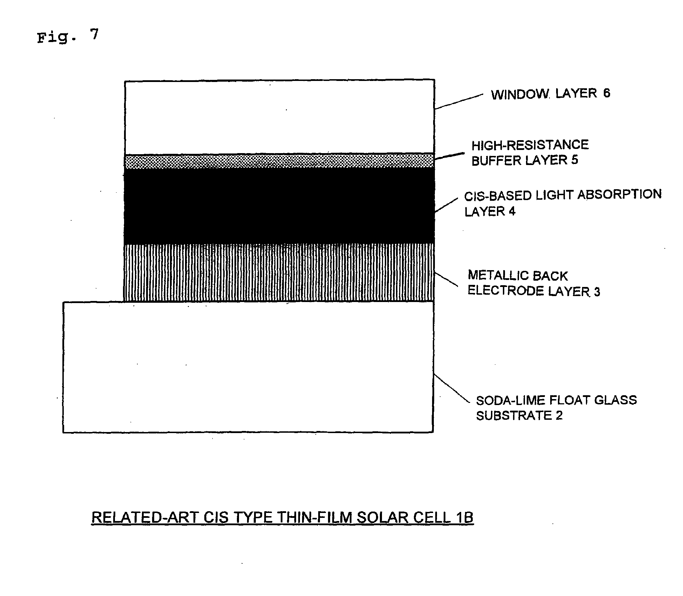

A CIS type thin-film solar cell 1B heretofore in use has a basic structure such as that shown in Fig. 7. It is a pn heterojunction device having a substrate structure comprising a substrate 2 comprising a soda-lime float glass and, superposed thereon in the following order, high-quality thin layers composed of a metallic back electrode layer (generally molybdenum) 3, a p-type CIS-based light absorption layer 4, a high-resistance buffer layer 5, and an n-type window layer (transparent conductive film) 6. In this CIS type thin-film solar cell 1, a soda-lime float glass is employed as the substrate 2 because it is inexpensive. However, since the work is heated to 500°C or higher, or to around 600°C in some cases, in the step of depositing the light absorption layer 4 on the metallic back electrode layer 3, alkali ingredients (e.g., Na, Ca, Mg, and K) thermally diffuse from the soda-lime float glass as the substrate 2 into the light absorption layer 4 due to this heat treatment. In case where these alkali ingredients thermally diffuse into the light absorption layer excessively, the light absorption layer 4 peels off at the interface of the metallic back electrode layer. Furthermore, in case where sodium, which has deliquescence, comes to be unevenly contained in the light absorption layer, this is a cause of instability or a reduced life of the light absorption layer itself, etc. Consequently, for attaining high quality/high performance and high reproducibility, it is necessary to block and control the diffusion of the alkali ingredients from the soda-lime float glass as a substrate. Usually, an alkali-barrier layer made of an oxide, nitride, or the like is deposited.

However, there are only an extremely small number of publications/reports on an investigation concerning an alkali-barrier layer, and there is no report which teaches the necessity of an alkali-barrier layer in the formation of a light absorption layer by the multi-source co-evaporation method. First investigations which have been published are ones in which influences of the deposition of an alkali-barrier layer on solar cell characteristics are discussed; while second investigations which have been published are ones employing a production process which comprises purposely depositing an alkali-barrier layer capable of completely preventing the diffusion of alkali ingredients from a soda-lime float glass substrate, depositing a metallic back electrode layer on the alkali-barrier layer, and separately further depositing a layer containing a necessary amount of sodium to produce a solar cell. These investigations each are one in which an independent alkali-barrier layer made of, e.g., an oxide or a nitride is deposited on a soda-lime float glass substrate, and do not have a constitution including an alkali-barrier layer having a two-layer structure composed of a silica layer and a first layer (comprising crystal grains having a regulated diameter) of a multilayered metallic back electrode layer as in the invention.

In the first investigations, influences of the deposition of an alkali-barrier layer on solar cell characteristics are discussed and it is concluded that an alkali-barrier layer is necessary (see, for example, non-patent documents 1 and 2). The second investigations are ones which comprise purposely depositing an alkali-barrier layer capable of completely preventing the diffusion of alkali ingredients from a soda-lime float glass substrate, depositing a metallic back electrode layer thereon, and separately further depositing a layer containing a necessary amount of sodium (see, for example, non-patent documents 3, 4, and 5).

Those investigations each are one in which an independent alkali-barrier layer made of, e.g., an oxide or a nitride is deposited on a soda-lime float glass substrate. The diffusion of alkali ingredients from a soda-lime float glass substrate relates to the method of film deposition (see, for example, non-patent document 6). On the other hand, it has been reported that a metallic back electrode layer alone having no alkali-barrier layer can only partly block the diffusion of alkali ingredients (see, for example, non-patent document 5).

Non-Patent Document 1: David F., Dawson-Elli, el. al: "Substrate Influences On CIS Device Performance" Proc. 1st World Conference of Photovoltaic Energy Conversion, (1995) 152-155
Non-Patent Document 2: C. Jensen: "The Study of Base Electrode/Substrate Interactions By Use of Air Anneal Imaging" Proc. 13th European Photovoltaic Solar Energy Conference, (1995)
Non-Patent Document 3: V. Probst, el. al: "Large Area CIS Formation By Rapid Thermal Processing of Stacked Elemental Layers" Proc. 17th European Photovoltaic Solar Energy Conference, (2002) 1005-1010
Non-Patent Document 4: V. Probst, el. al: "Advanced Stacked a CIS Formation By Rapid Thermal Processing Of Stacked Elemental Layer Process For Cu(InGa)Se2 Thin Film Photvoltaic Devices" Mat. Res. Soc. Symp. Proc., Vol.426 (1996) 165-176
Non-Patent Document 5: J. Holz, el. al: Proc. 12th European Photovoltaic Solar Energy Conference, (1994) 1592-1595
Non-Patent Document 6: R.J. Araujo, el. al: "Sodium Redistribution Between Oxide Phases" Journal of Non-Cristalline solids, 197 (1996) 154-163

### DISCLOSURE OF THE INVENTION

### PROBLEMS THAT THE INVENTION IS TO SOLVE

As described above, the alkali-barrier layers of the CIS type thin-film solar cells in the investigations which have been published so far are independent ultrathin layers made of, e.g., an oxide or a nitride. As apparent from those investigations, it is necessary to increase the thickness of such an alkali-barrier layer for completely blocking the diffusion of alkali ingredients from the soda-lime float glass substrate and it is necessary to independently deposit the layer. Consequently, there is the necessity of purchasing as a substrate a soda-lime float glass on which an alkali-barrier layer as thick as 50-200 nm has been deposited, and this has been a cause of a cost increase.
On the other hand, for improving the output characteristics of a CIS type thin-film solar cell, it is necessary to regulate the conductivity of the CIS-based light absorption layer so as to be within a certain range. For attaining this, alkali ingredient diffusion from the soda-lime float glass substrate is necessary and, hence, a barrier layer which permits leakage and enables alkali ingredients to thermally diffuse in some degree is necessary. However, the amount of alkali ingredients to be diffused cannot be sufficiently controlled.
Accordingly, an object of the invention is to provide a production process by which an alkali-barrier layer capable of controlling the amount of alkali ingredients to be diffused and necessary for forming a high-quality light absorption layer is formed with high reproducibility, in order to improve solar cell performances (e.g., conversion efficiency and open-circuit voltage).

Another object of the invention is to provide a production process in which alkali ingredient diffusion from a soda-lime float glass substrate can be secured in an amount necessary for forming a CIS-based light absorption layer having device characteristics capable of attaining a high conversion efficiency.

Furthermore, in the production process which comprises purposely depositing an alkali-barrier layer capable of completely preventing the diffusion of alkali ingredients from a soda-lime float glass substrate, depositing a metallic back electrode layer thereon, and separately further depositing a layer containing a necessary amount of sodium, there has been a problem that this process defeats the purpose of reducing cost because the process necessitates an increased raw-material cost and a larger number of steps, leading to a cost increase. Accordingly, still another object of the invention is to provide a production process which eliminates the necessity of a production process comprising the step of depositing an alkali-barrier layer capable of completely preventing the diffusion of alkali ingredients from a soda-lime float glass substrate and the step of depositing a sodium-containing layer.

The related-art deposition of a thin layer of an oxide, nitride, or the like by the RF sputtering method using a ceramic target, e.g., an oxide or a nitride, has a low deposition rate. Although the technique in which the deposition of a metallic back electrode layer by the DC sputtering method, which can attain a high deposition rate, is continuously conducted in the same sputtering apparatus at a constant substrate conveyer speed is a method effective in cost reduction, deposition pressure regulation therein is difficult and there has hence been a problem that it is difficult to optimize each of the thin layer of an oxide, a nitride, or the like and the metallic back electrode layer.
Accordingly, a further object of the invention is to provide a production process in which a thin layer of an oxide, a nitride, or the like and a metallic back electrode layer can be successively deposited in the same sputtering apparatus at a constant substrate conveyer speed or rotation speed.

For successively depositing a thin layer of an oxide, a nitride, or the like and a metallic back electrode layer in the same sputtering apparatus at a constant substrate conveyer speed, use may be made of a method in which the part corresponding to a thin layer of an oxide, a nitride, or the like is deposited by the DC sputtering method using a metal target alloyed with boron (B) or the like (e.g., silicon metal-boron target in the case of silica film) in an argon gas containing oxygen by reactive sputtering. In this case, when the oxygen comes into the metallic-back-electrode layer deposition chamber for depositing the part corresponding to a metallic back electrode layer, then the target used for forming a metallic back electrode layer and/or the metallic back electrode layer itself is oxidized and this is a cause of an increase in resistance. Because of this, a high-performance isolation system for completely preventing gas mixing between the deposition chamber for depositing a thin film of an oxide, a nitride, or the like and the deposition chamber for depositing a metallic back electrode layer is necessary. There has hence been a problem that the apparatus cost increases.
Accordingly, still a further object of the invention is to provide a production process which is free from the risk of causing an increase in resistance due to the oxidation of the metallic back electrode layer and does not increase the apparatus cost and in which a high-quality alkali-barrier layer and a high-quality metallic back electrode layer are successively deposited in the same sputtering apparatus at a constant substrate conveyer speed.

### MEANS FOR SOLVING THE PROBLEMS

(1) The invention, which eliminates the problems described above, provides a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer has an alkali-barrier function for preventing and controlling the thermal diffusion of alkali ingredients from the glass substrate into the light absorption layer when the light absorption layer is deposited.

(2) The invention provides a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the first layer of the multilayered metallic back electrode layer have an alkali-barrier function for preventing and controlling the thermal diffusion of alkali ingredients from the glass substrate into the light absorption layer when the light absorption layer is deposited.

(3) The invention provides the CIS type thin-film solar cell as described under (1) or (2) above, wherein the alkali-free layer comprises an oxide or a nitride.

(4) The invention provides the CIS type thin-film solar cell as described under (1), (2), or (3) above, wherein the alkali-free layer comprises an oxide, a nitride, or a special compound, and desirably comprises silica (SiO₂ or SiO₂₋ₓ).

(5) The invention provides the CIS type thin-film solar cell as described under any one of (1) to (4) above, wherein the alkali-free layer comprises silica having the stoichiometric composition (SiO₂) and/or silica which does not have the stoichiometric composition and tends to be somewhat deficient in oxygen (SiO₂₋ₓ).

(6) The invention provides the CIS type thin-film solar cell as described under any one of (1) to (5) above, wherein the alkali-free layer has a thickness in the range of 3-100 nm, desirably 20-50 nm.

(7) The invention provides the CIS type thin-film solar cell as described under (2) above, wherein the first layer of the metallic back electrode layer comprises crystal grains of the metal which are fine grains having a high density and having a regulated crystal grain diameter.

(8) The invention provides the CIS type thin-film solar cell as described under (2) above, wherein the total thickness of the alkali-free layer and the first layer of the metallic back electrode layer is 50-110 nm.

(9) The invention provides the CIS type thin-film solar cell as described under (1) or (2) above, wherein the multilayered metallic back electrode layer comprises Mo (molybdenum) and has a multilayer structure composed of two or more layers.

(10) The invention provides the CIS type thin-film solar cell as described under (1), (2), or (9) above, wherein the multilayered metallic back electrode layer has a thickness in the range of 100-1,000 nm, desirably in the range of 300-500 nm.

(11) The invention provides a process for producing a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the multilayered metallic back electrode layer directly overlying the alkali-free layer are formed by a method which comprises depositing the alkali-free layer on the glass substrate, thereafter depositing the multilayered metallic back electrode layer on the alkali-free layer, and imparting to the alkali-free layer an alkali-barrier function for preventing and controlling the thermal diffusion of alkali ingredients from the glass substrate into the light absorption layer when the light absorption layer is deposited.

(12) The invention provides a process for producing a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the multilayered metallic back electrode layer are formed by a method which comprises depositing the alkali-free layer on the glass substrate, thereafter depositing the multilayered metallic back electrode layer on the alkali-free layer using changed deposition conditions in depositing the first layer of the multilayered metallic back electrode layer to thereby regulate the crystal grain diameter thereof, and imparting to the alkali-free layer and the first layer of the metallic back electrode layer an alkali-barrier function for preventing and controlling the thermal diffusion of alkali ingredients from the glass substrate into the light absorption layer when the light absorption layer is deposited.

(13) The invention provides the process for producing a CIS type thin-film solar cell as described under (11) or (12) above, wherein the alkali-free layer is deposited by the RF sputtering method in an inert gas, e. g., argon gas, using a silica target or by the reactive DC sputtering method in a gaseous mixture of argon gas and oxygen using one or more silicon metal targets alloyed with a metallic element, e.g., boron, for imparting conductivity to metallic silicon.

(14) The invention provides the process for producing a CIS type thin-film solar cell as described under (11) or (12) above, wherein the electric power to be applied to the target (s) during the deposition of the alkali-free layer by sputtering is in the range of 0.5-1.5 Watt/cm² in the RF sputtering method and is in the range of 1.0-3.0 Watt/cm² in the DC sputtering method, and the electric power is determined so that the first layer of the metallic back electrode layer comprises crystal grains which are fine grains having a grain diameter (grain size) of 10 nm or smaller, desirably in the range of 3-5 nm.

(15) The invention provides the process for producing a CIS type thin-film solar cell as described under (11) or (12) above, wherein the deposition pressure during the deposition of the alkali-free layer by sputtering is in the range of 0.5-5 Pa (pascals), desirably in the range of 0.5-1.5 Pa (pascals), and the deposition pressure is determined so that the first layer of the metallic back electrode layer comprises fine grains having a grain diameter in the range of 3-5 nm.

(16) The invention provides the process for producing a CIS type thin-film solar cell as described under (11) or (12) above, wherein the electric power to be applied to the target during the deposition of the first layer of the multilayered metallic back electrode layer by sputtering is in the range of from 1/8 to 1/2 of the electric power to be applied to the target during the deposition by sputtering of the metallic back electrode layer directly overlying the first layer, and by thus regulating the voltage to be applied to the target, the first layer is made to comprise fine grains having a grain diameter of 10 nm or smaller, desirably 3-5 nm, and having a high density.

(17) The invention provides the process for producing a CIS type thin-film solar cell as described under (11) or (12) above, wherein the multilayered metallic back electrode layer is continuously deposited at a constant substrate conveyer speed.

(18) The invention provides the process for producing a CIS type thin-film solar cell as described under (11) or (12) above, wherein the multilayered metallic back electrode layer is deposited by the DC sputtering method in an argon gas as an inert gas using a metal (e.g., molybdenum (Mo)) as a target.

(19) The invention provides the process for producing a CIS type thin-film solar cell as described under (11) or (12) above, wherein the multilayered metallic back electrode layer comprises any one refractory metal selected from metals having resistance to selenium, such as molybdenum (Mo), titanium (Ti), and tantalum (Ta), or a combination thereof resulting from the formation of a compound (e.g., MoSiOₓ, etc.) with the silica layer.

(20) The invention provides the process for producing a CIS type thin-film solar cell as described under (11) or (12) above, wherein a pressure regulation mechanism and/or an independent vacuum system is disposed between an alkali-free-layer deposition chamber for depositing the alkali-free layer and a metallic-back-electrode layer deposition chamber for depositing the metallic back electrode layer and the two thin layers are deposited in respective sputtering gas atmospheres (e.g., argon gas, Ar+O₂ mixture gas) differing in pressure and/or composition.

### ADVANTAGES OF THE INVENTION

According to the invention, although the step of forming an alkali-barrier layer is newly conducted, a metallic back electrode layer can be successively deposited in the same sputtering apparatus and the excess thermal diffusion of alkali ingredients into the light absorption layer can be prevented and controlled. As a result, the light absorption layer can be prevented from peeling off at the interface of the metallic back electrode layer without reducing solar cell performances (conversion efficiency and open-circuit voltage). Thus, an improved yield and a cost reduction can be attained.

The invention is applicable to a ceramic target which is an oxide or nitride having no electrical conductivity. According to the invention, two or more deposition steps for depositing different materials can be conducted in the same in-line type sputtering apparatus by depositing a silica layer using a silica target attaining high insulating properties by the RF sputtering method, which has a low deposition rate because a high power cannot be applied, and depositing the first layer of a multilayered metallic back electrode layer successively to the silica layer deposition by the DC sputtering method, in which the deposition rate can be improved by increasing the power to be applied, at the same deposition pressure and the same substrate conveyer speed.

Furthermore, the invention can eliminate the problems associated with differences in deposition conditions between two different sputtering methods to thereby enable film deposition to be conducted at the same substrate conveyance speed.

Moreover, according to the invention, film deposition in common argon gas at the same pressure (same argon gas flow rate) is possible. Thus, a two-layer structure can be formed by depositing a silica layer by the RF sputtering method and successively depositing the first layer of amultilayeredmetallic back electrode layer by the DC sputtering method. By causing this two-layer structure to function as an alkali-barrier layer, a greatly improved deposition rate and a reduction in apparatus cost are attained.

In addition, since there is no need of purchasing a soda-lime float glass substrate having an alkali-barrier layer, the invention can contribute to a reduction of the cost of a CIS type thin-film solar cell.

### BEST MODE FOR CARRYING OUT THE INVENTION

Embodiments of the invention will be explained below.
The invention relates to a method of forming an alkali-barrier layer 8 for preventing and controlling the thermal diffusion of alkali ingredients from a soda-lime float glass substrate 2 into a light absorption layer 4 comprising a p-type semiconductor when the light absorption layer is deposited on a metallic back electrode layer 3 deposited on the soda-lime float glass substrate 2. The invention further relates to a CIS type thin-film solar cell 1 having the alkali-barrier layer 8.
This alkali-barrier layer 8 may be a first alkali-barrier layer which is a silica layer 7 formed on the soda-lime float glass substrate, or may be a second alkali-barrier layer which is a multilayered alkali-barrier layer composed of the silica layer 7 and the first layer 3a of the multilayered metallic back electrode layer directly overlying the silica layer 7.

The CIS type thin-film solar cell 1 of the invention has a basic structure such as that shown in Fig. 7. It is a pn heterojunction device having a substrate structure comprising a substrate 2 comprising a soda-lime float glass and, superposed thereon in the following order, high-quality thin layers composed of a metallic back electrode layer (generally molybdenum) 3, a p-type CIS-based light absorption layer 4, a high-resistance buffer layer 5, and an n-type window layer (transparent conductive film) 6. The light absorption layer 4 comprises a p-type semiconductor such as a thin multinary-compound semiconductor film, in particular, aI-III-VI₂ Group chalcopyrite semiconductor, e.g., copper indium diselenide (CuInSe₂), copper indium gallium diselenide (CuInGaSe₂), copper gallium diselenide (CuGaSe₂), copper indium gallium disulfo-selenide (Cu(InGa) (SSe)₂), copper indium disulfide (CuInS₂), copper gallium disulfide (CuGaS₂) , copper indium gallium disulfide (CuInGaS₂), or copper indium gallium diselenide (CuInGaSe₂) having a thin film of copper indium gallium disulfo-selenide (Cu(InGa) (SSe)₂) as a surface layer.

In the CIS type thin-film solar cell 1, a soda-lime float glass is employed as the substrate 2 because it is inexpensive. However, since the work is heated to 500°C or higher, or to around 600°C in some cases, in the step of depositing the light absorption layer 4 on the metallic back electrode layer 3, alkali ingredients (e.g., Na, Ca, Mg, and K) thermally diffuse from the soda-lime float glass as the substrate 2 into the light absorption layer 4 due to this heat treatment. In case where these alkali ingredients thermally diffuse into the light absorption layer excessively, the light absorption layer 4 peels off at the interface of the metallic back electrode layer. Furthermore, in case where sodium, which has deliquescence, comes to be unevenly contained in the light absorption layer, this is a cause of instability or a reduced life of the light absorption layer itself, etc.

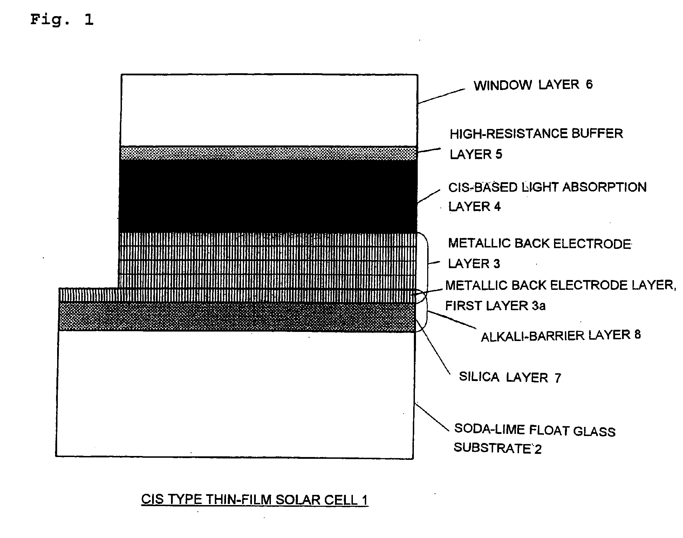

In the invention, such problems are eliminated by forming an alkali-barrier layer 8, as shown in Fig. 1, for preventing and controlling the thermal diffusion of alkali ingredients from a soda-lime float glass substrate 2 into a light absorption layer comprising a p-type semiconductor when the light absorption layer 4 is deposited on a metallic back electrode layer 3 deposited on the soda-lime float glass substrate 2. The alkali-barrier layer 8 may be: a first alkali-barrier layer which consists only of an alkali-free silica layer 7 formed on the soda-lime float glass substrate; or a second alkali-barrier layer which is a multilayered alkali barrier layer composed of the silica layer 7 and the first layer 3A of the multilayeredmetallic back electrode layer directly overlying the silica layer 7, the first layer 3A having a regulated crystal grain diameter. The metallic back electrode layer 3 has a multilayer structure composed of two or more layers. A metallic back electrode layer 3 having a single-layer structure may be employed although this results in a slight decrease in the effect of peeling resistance.

The alkali-free layer 7 comprises an oxide, a nitride, or a special compound, and desirably comprises silica. Specifically, silica having the stoichiometric composition (SiO₂) and/or silica which does not have the stoichiometric composition and tends to be somewhat deficient in oxygen (SiO₂₋ₓ) is suitable. The thickness of the alkali-free (silica) layer may be in the range of 3-100 nm, desirably 20-50 nm.

The multilayered metallic back electrode layer 3 may have a multilayer structure composed of three or more layers, and may be made of Mo (molybdenum). The first layer 3a of the metallic back electrode layer 3 may comprise crystal grains of the metal which are fine grains and have a high density. The thickness thereof may be in the range of 10-100 nm, desirably 30-60 nm. The thickness of the multilayered metallic back electrode layer 3 may be in the range of 100-1,000 nm, desirably in the range of 300-500 nm.

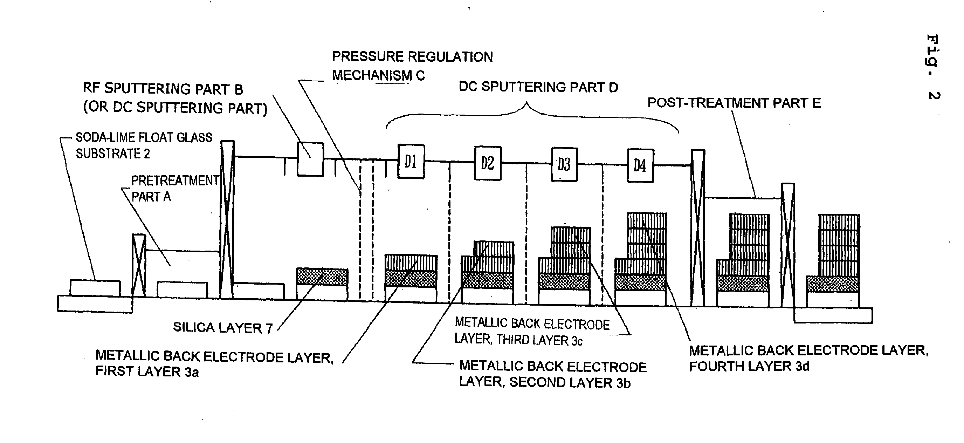

An example of apparatus for forming the alkali-barrier layer 8 according to the invention is shown in Fig. 2, and a method of forming the alkali-barrier layer 8 is explained below.
The following method may be employed for eliminating an unbalance in deposition rate and an increase in apparatus cost. First, a silica layer 7 which is alkali-free is deposited in an RF sputtering part B either by the RF sputtering method using an alkali-free stable silica target or by the reactive DC sputtering method in an Ar+O₂ mixed gas atmosphere using an Si-B alloy target which is an alloy with boron or the like for improving electrical conductivity. Subsequently, film deposition is conducted in a DC sputtering part D in the same sputtering apparatus by the DC sputtering method, in which an increased deposition rate can be used. Namely, subsequently to the deposition of the silica film, film deposition is conducted in DC sputtering parts D1, D2, D3, and D4 at the same deposition pressure and the same substrate conveyer speed using argon gas as a sputtering gas to form a multilayered metallic back electrode layer 3. As a result, an alkali-barrier layer is formed which has high quality and a necessary thickness and has a two-layer structure composed of the silica layer 7 and that first layer 3a of the metallic back electrode layer which has been formed while regulating the power being applied. Even the silica layer 7 alone can be made to have an alkali-barrier function by regulating the thickness thereof as stated above. Incidentally, a pressure regulation mechanism C may be disposed between the RF sputtering part (alkali-free-layer deposition chamber) for depositing the silica layer 7 and the DC sputtering part D (metallic-back-electrode layer deposition chamber) for depositing the metallic back electrode layer 3, whereby the two thin layers can be formed respectively using different pressures and different sputtering gas compositions (e.g., Ar+O₂ mixed gas in the reactive DC sputtering method).

The deposition of a silica layer 7 is specifically as follows. One or more silica targets are used to deposit the film by the RF sputtering method in an inert gas (argon gas). Alternatively, one or more silicon metal targets alloyed with a metallic element, e.g., boron, for imparting conductivity to metallic silicon are used to deposit the film by the reactive DC sputtering method in a gaseous mixture of argon gas and oxygen. The electric power to be applied to the target(s) during the deposition by sputtering maybe in the range of 0.5-1.5 Watt/cm² in the RF sputtering method and may be in the range of 1.0-3.0 Watt/cm² in the DC sputtering method. In either case, the electric power to be applied may be determined so as to result in fine crystal grains having a diameter of 10 nm or smaller, desirably in the range of 3-5 nm. The deposition pressure during the deposition of the silica layer 7 by sputtering may be regulated to a value in the range of 0.5-5 Pa (pascals), desirably in the range of 0.5-1.5 Pa (pascals), so as to result in fine grains having a grain diameter in the range of 3-5 nm.

As stated above, the multilayered metallic back electrode layer is continuously deposited by the DC sputtering method at a constant substrate conveyer speed or rotation speed. In this operation, any one refractory metal selected from metals having resistance to selenium, such as molybdenum (Mo), titanium (Ti), and tantalum (Ta), or metals comprising a combination of any of these (e.g., molybdenum (Mo)) resulting from the formation of a crystalline structure (e.g., MoSiOₓ, etc.) with the silica layer are used as a target to deposit the metallic back electrode layer by the DC sputtering method in an argon gas as an inert gas. In depositing the first layer 3a of the metallic back electrode layer, the voltage to be applied to the target is regulated to thereby form crystal grains of the metal which are fine grains and have a high density.

In the deposition of the first layer 3a of the multilayered metallic back electrode layer, the electric power to be applied to the target during the deposition by sputtering may be in the range of from 1/8 to 1/2 of the electric power to be applied to the target during the deposition by sputtering of the metallic back electrode layer 3 directly overlying the first layer, and may be determined so as to result in a crystal grain diameter of 10 nm or smaller, desirably in the range of 3-5 nm.
The deposition pressure during the deposition by sputtering may be in the range of 0.5-1.5 Pa (pascals) and determined so as to result in a grain diameter of 10 nm or smaller, desirably in the range of 3-5 nm.

Advantages of CIS type thin-film solar cell 1 of the invention described above, which have an alkali-barrier layer, are explained below.
Table 1 given below shows a comparison in performance between the CIS type thin-film solar cells 1A of the invention, which have an alkali-barrier layer, and a related-art CIS type thin-film solar cell 1B having no alkali-barrier layer.

**[Table 1]**

| Comparison in performance between CIS type thin-film solar cells of the invention and related-art CIS type thin-film solar cell | |
|---|---|
| Structure of alkali-barrier layer | Examination results |
| Related-art CIS type thin-film solar cell; | · Metallic back electrode layer peels off at the interface of a soda-lime float glass substrate. |
| no alkali-barrier layer (no silica layer and no first layer in the metallic back electrode layer) | · CIS-based light absorption layer peels off at the interface of metallic back electrode layer. |
| CIS type thin-film solar cell of the invention; | · CIS-based light absorption layer peels off a metallic back electrode layer. |
| having a silica layer only; no first layer in the metallic back electrode layer | · Round spots of different color are found on the surface of a metallic back electrode layer. |
| CIS type thin-film solar cell of the invention; | · CIS-based light absorption layer does not peel off at the interface of a metallic back electrode |
| having an alkali-barrier layer | layer. |
| (having a silica layer and the first layer in metallic back electrode layer) | · Round spots of different color are found slightly on the surface of a metallic back electrode layer, but the surface of the metallic back electrode layer as a whole is fine. |

As shown above, in the case where an alkali-barrier layer is not present (neither a silica layer nor that first layer of a metallic back electrode layer which has a regulated crystal grain diameter is present) as in the related-art CIS type thin-film solar cell 1B, alkali ingredients are thermally diffused excessively into the light absorption layer and this CIS-based light absorption layer has poor adhesion to the metallic back electrode layer and peels off at the interface between the light absorption layer and the metallic back electrode layer. Also in the case where the metallic back electrode layer does not have the first layer, the light absorption layer has poor adhesion to the metallic back electrode layer and peels off at the interface between the light absorption layer and the metallic back electrode layer. In the case of the CIS type thin-film solar cell 1A of the invention in which the alkali-barrier layer consists of a silica layer alone, the metallic back electrode layer does not peel off at the interface of the glass substrate. In this case, however, a phenomenon occurs in which the CIS-based light absorption layer peels off at the interface of the metallic back electrode layer to form round spots of a different color in the surface of the metallic back electrode layer. In contrast, in the case where the alkali-barrier layer is composed of a silica layer and the first layer of a metallic back electrode layer, this solar cell is free from the peeling of the metallic back electrode layer from the glass substrate and the peeling of the CIS-based light absorption layer from the metallic back electrode layer, and the round spots of a different color on the surface of the metallic back electrode layer are considerably diminished.

As a result, although the step of forming an alkali-barrier layer is newly conducted, film deposition can be conducted in the same sputtering apparatus and troubles such as the peeling of the metallic back electrode layer from the glass substrate and peeling at the interface between the light absorption layer and the metallic back electrode layer are prevented. Consequently, the product yield in the production of solar cells is improved and a cost reduction is attained.

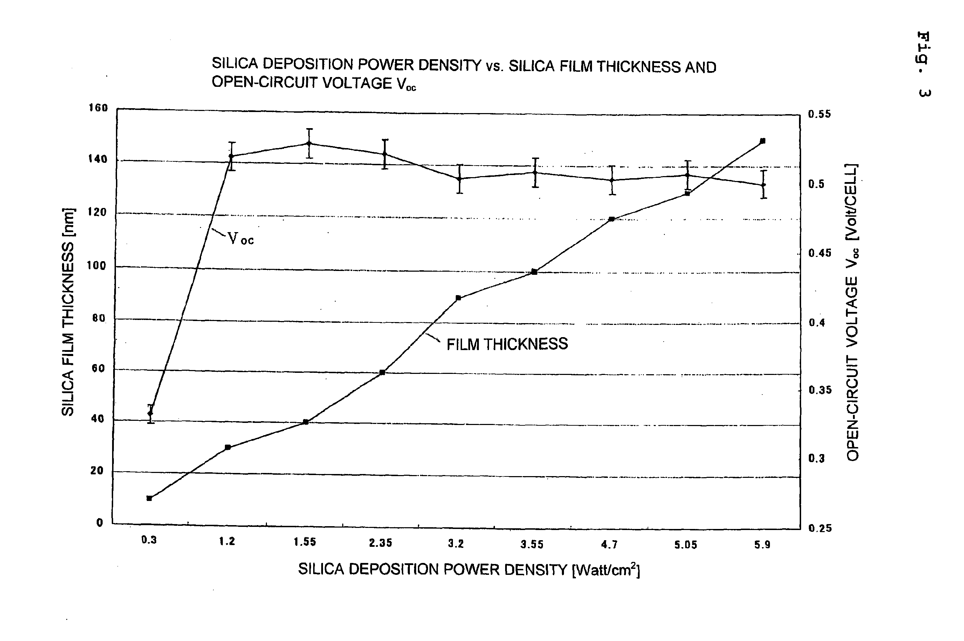

An example of conditions for forming a silica layer (silica layer deposition pressure) in the alkali-barrier layer according to the invention is shown in Fig. 3.
The figure shows changes of the thickness of the silica layer deposited and changes of the open-circuit voltage (Volt/cell) of a CIS type thin-film solar cell having this silica layer with changes in silica deposition pressure (Pa) in silica deposition at a constant applied power (power density) of 1.0 Watt/cm².
As the silica deposition pressure (Pa) increases, the silica film thickness increases. However, the open-circuit voltage is almost constant.

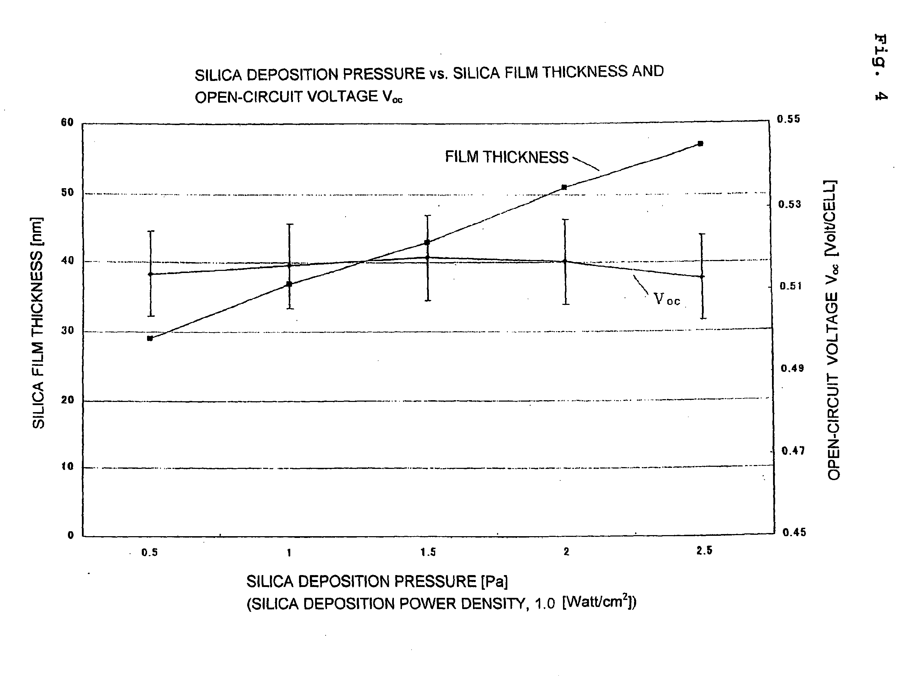

An example of conditions for forming a silica layer (sputtering power to be applied for silica layer deposition) in the alkali-barrier layer according to the invention is shown in Fig. 4.
The figure shows changes of the thickness of the silica layer deposited and changes of the open-circuit voltage (Volt/cell) of a CIS type thin-film solar cell having this silica layer with changes in silica layer deposition power density (Watt/cm²).
As the silica deposition power density (w/cm²) increases, the silica film thickness increases. However, the open-circuit voltage is almost constant.

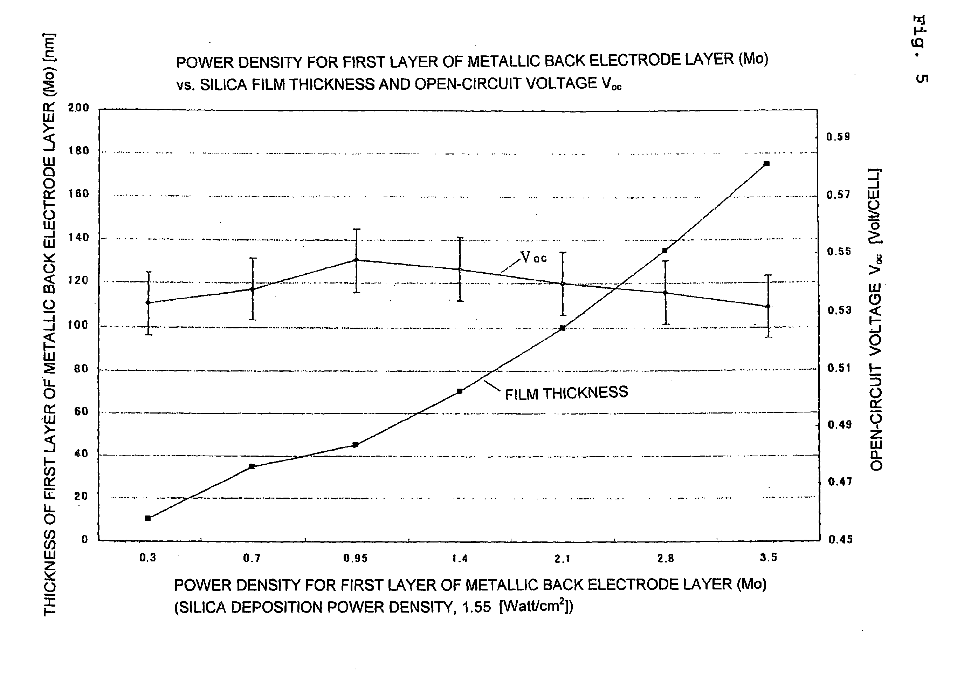

An example of conditions for forming the first layer of a metallic back electrode layer (deposition pressure for the first layer of metallic back electrode layer) in the alkali-barrier layer according to the invention is shown in Fig. 5.
Silica layer deposition was conducted at a deposition power density of 1.55 (Watt/cm²) and the first layer of a metallic back electrode layer was formed while changing the deposition pressure (Pa) among deposition conditions. The figure shows changes of the thickness of the first layer of the metallic back electrode layer deposited and changes of the open-circuit voltage (Volt/cell) of a CIS type thin-film solar cell having the silica layer and first layer of the metallic back electrode layer deposited under those conditions, with changes in the deposition pressure (Pa).
As the deposition pressure (Pa) increases, the thickness of the first layer of the metallic back electrode layer increases. However, the open-circuit voltage of the CIS type thin-film solar cell is almost constant.

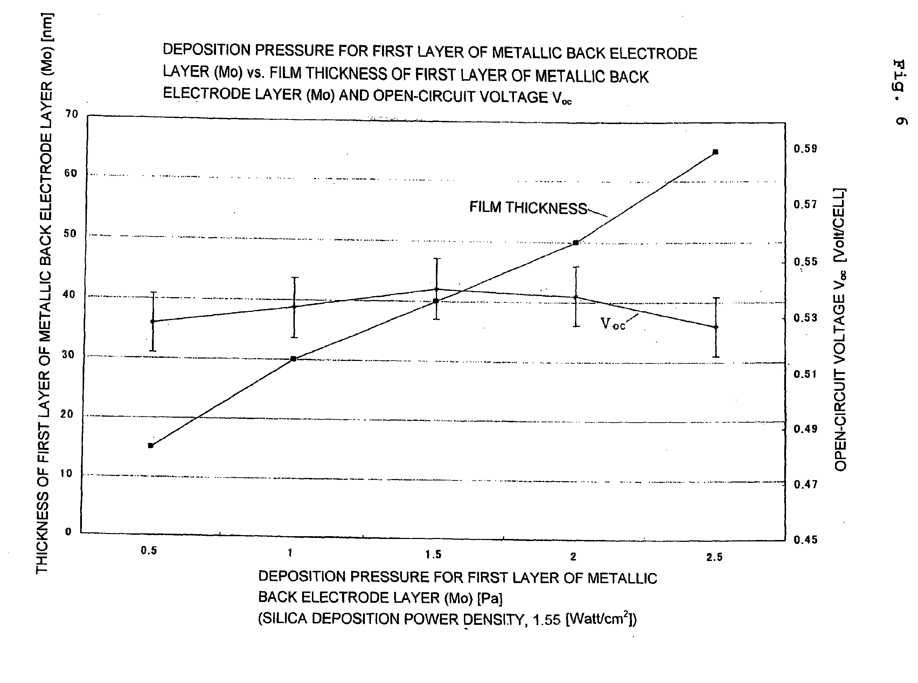

An example of conditions for forming the first layer of a metallic back electrode layer (sputtering power to be applied for the first layer of the metallic back electrode layer) in the alkali-barrier layer according to the invention is shown in Fig. 6.
Silica layer deposition was conducted at a deposition power density of 1.55 (Watt/cm²) and the first layer of a metallic back electrode layer was formed while changing the power density (Watt/cm²) among deposition conditions. The figure shows changes of the thickness of the first layer of the metallic back electrode layer and changes of the open-circuit voltage (Volt/cell) of a CIS type thin-film solar cell having the silica layer and the first layer of the metallic back electrode layer deposited under those conditions, with changes in the power density (Watt/cm²) .
As the power density (Watt/cm²) increases, the thickness of the first layer of the metallic back electrode layer increases. However, the open-circuit voltage of the CIS type thin-film solar cell is almost constant.

### BRIEF DESCRIPTION OF THE DRAWINGS

[Fig. 1] Fig. 1 is a view (sectional view) showing the structure of a CIS type thin-film solar cell of the invention.
[Fig. 2] Fig. 2 shows an apparatus for forming the alkali-barrier layer of a CIS type thin-film solar cell of the invention.
[Fig.3] Fig. 3 is a presentation showing the relationship between the deposition pressure (changes thereof) in the deposition of a silica layer in the alkali-barrier layer of a CIS type thin-film solar cell of the invention and each of the thickness of the silica layer and the open-circuit voltage of the thin-film solar cell having the layer.
[Fig. 4] Fig. 4 is a presentation showing the relationship between the power density (changes thereof) in the deposition of a silica layer in the alkali-barrier layer of a CIS type thin-film solar cell of the invention and each of the thickness of the silica layer and the open-circuit voltage of the thin-film solar cell having the layer.
[Fig. 5] Fig. 5 is a presentation showing the relationship between the deposition pressure (changes thereof) in the deposition of the first layer of a metallic back electrode layer in the alkali-barrier layer of a CIS type thin-film solar cell of the invention and each of the thickness of the first layer of the metallic back electrode layer and the open-circuit voltage of the thin-film solar cell having the layer.
[Fig. 6] Fig. 6 is a presentation showing the relationship between the power density (changes thereof) in the deposition of the first layer of ametallicback electrode layer in the alkali-barrier layer of a CIS type thin-film solar cell of the invention and each of the thickness of the first layer of the metallic back electrode layer and the open-circuit voltage of the thin-film solar cell having the layer.
[Fig. 7] Fig. 7 is a view (sectional view) showing the structure of a related-art CIS type thin-film solar cell.

### DESCRIPTION OF REFERENCE NUMERALS AND SIGNS

- 1: CIS type thin-film solar cell
- 2: soda-lime float glass substrate
- 3: metallic back electrode layer
- 3a: metallic back electrode layer, first layer
- 3b: metallic back electrode layer, second layer
- 3c: metallic back electrode layer, third layer
- 3d: metallic back electrode layer, fourth layer
- 4: CIS-based light absorption layer
- 5: high-resistance buffer layer
- 6: window layer
- 7: silica layer
- A: loading lock part
- B: RF sputtering part (or DC sputtering part)
- C: pressure regulation mechanism
- D: DC sputtering part
- D1: first DC sputtering part
- D2: second DC sputtering part
- D3: third DC sputtering part
- D4: fourth DC sputtering part
- E: unloading lock part

## Claims

1. A CIS type thin-film solar cell which is a pn heterojunction device having a substrate structure, which comprises a glass substrate, an alkali-free layer, a multilayered metallic back electrode layer, a p-type CIS-based light absorption layer, a high-resistance buffer layer, and an n-type window layer which have been superposed in this order, wherein the alkali-free layer has an alkali-barrier function for preventing and controlling the thermal diffusion of alkali ingredients from the glass substrate into the light absorption layer when the light absorption layer is deposited.

2. A CIS type thin-film solar cell which is a pn heterojunction device having a substrate structure, which comprises a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the first layer of the multilayered metallic back electrode layer have an alkali-barrier function for preventing and controlling the thermal diffusion of alkali ingredients from the glass substrate into the light absorption layer when the light absorption layer is deposited.

3. The CIS type thin-film solar cell according to claim 1 or 2, wherein the alkali-free layer comprises an oxide or a nitride.

4. The CIS type thin-film solar cell according to claim 1, 2, or 3, wherein the alkali-free layer comprises an oxide, a nitride, or a special compound, and desirably comprises silica (SiO₂ or SiO₂₋ₓ).

5. The CIS type thin-film solar cell according to any one of claims 1 to 4, wherein the alkali-free layer comprises silica having the stoichiometric composition (SiO₂) and/or silica which does not have the stoichiometric composition and tends to be somewhat deficient in oxygen (SiO₂₋ₓ).

6. The CIS type thin-film solar cell according to any one of claims 1 to 5, wherein the alkali-free layer has a thickness in the range of 3-100 nm, desirably 20-50 nm.

7. The CIS type thin-film solar cell according to claim 2, wherein the first layer of the metallic back electrode layer comprises crystal grains of the metal which are fine grains having a high density and having a regulated crystal grain diameter.

8. The CIS type thin-film solar cell according to claim 2, wherein the total thickness of the alkali-free layer and the first layer of the metallic back electrode layer is 50-110 nm.

9. The CIS type thin-film solar cell according to claim 1 or 2, wherein the multilayered metallic back electrode layer comprises Mo (molybdenum) and has a multilayer structure composed of two or more layers.

10. The CIS type thin-film solar cell according to claim 1, 2, or 9, **characterized in that** the multilayered metallic back electrode layer has a thickness in the range of 100-1,000 nm, desirably in the range of 300-500 nm.

11. A process for producing a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the multilayered metallic back electrode layer directly overlying the alkali-free layer are formed by a method which comprises depositing the alkali-free layer on the glass substrate, thereafter depositing the multilayered metallic back electrode layer on the alkali-free layer, and imparting to the alkali-free layer an alkali-barrier function for preventing and controlling the thermal diffusion of alkali ingredients from the glass substrate into the light absorption layer when the light absorption layer is deposited.

12. A process for producing a CIS type thin-film solar cell which is a pn heterojunction device having a substrate structure comprising a glass substrate, an alkali-free layer, a multilayered metallic back electrode layer, a p-type CIS-based light absorption layer, a high-resistance buffer layer, and an n-type window layer which have been superposed in this order, wherein the alkali-free layer and the multilayered metallic back electrode layer are formed by a method which comprises depositing the alkali-free layer on the glass substrate, thereafter depositing the multilayered metallic back electrode layer on the alkali-free layer using changed deposition conditions in depositing the first layer of the multilayered metallic back electrode layer to thereby regulate the crystal grain diameter thereof, and imparting to the alkali-free layer and the first layer of the metallic back electrode layer an alkali-barrier function for preventing and controlling the thermal diffusion of alkali ingredients from the glass substrate into the light absorption layer when the light absorption layer is deposited.

13. The process for producing a CIS type thin-film solar cell according to claim 11 or 12, wherein the alkali-free layer is deposited by the RF sputtering method in an inert gas, e.g., argon gas, using a silica target or by the reactive DC sputtering method in a gaseous mixture of argon gas and oxygen using one or more silicon metal targets alloyed with a metallic element, e.g., boron, for imparting conductivity to metallic silicon.

14. The process for producing a CIS type thin-film solar cell according to claim 11 or 12, wherein the electric power to be applied to the target(s) during the deposition of the alkali-free layer by sputtering is in the range of 0.5-1.5 Watt/cm² in the RF sputtering method and is in the range of 1.0-3.0 Watt/cm² in the DC sputtering method, and the electric power is determined so that the first layer of the metallic back electrode layer comprises crystal grains which are fine grains having a grain diameter of 10 nm or smaller, desirably in the range of 3-5 nm.

15. The process for producing a CIS type thin-film solar cell according to claim 11 or 12, wherein the deposition pressure during the deposition of the alkali-free layer by sputtering is in the range of 0.5-5 Pa (pascals), desirably in the range of 0.5-1.5 Pa (pascals), and the deposition pressure is determined so that the first layer of the metallic back electrode layer comprises fine grains having a grain diameter in the range of 3-5 nm.

16. The process for producing a CIS type thin-film solar cell according to claim 12, wherein the electric power to be applied to the target during the deposition of the first layer of the multilayered metallic back electrode layer by sputtering is in the range of from 1/8 to 1/2 the electric power to be applied to the target during the deposition by sputtering of the metallic back electrode layer directly overlying the first layer and that by thus regulating the voltage to be applied to the target, the first layer is made to comprise fine grains having a grain diameter of 10 nm or smaller, desirably 3-5 nm, and having a high density.

17. The process for producing a CIS type thin-film solar cell according to claim 11 or 12, wherein the multilayered metallic back electrode layer is continuously deposited at a constant substrate conveyer speed.

18. The process for producing a CIS type thin-film solar cell according to claim 11 or 12, wherein the multilayered metallic back electrode layer is deposited by the DC sputtering method in an argon gas as an inert gas using a metal (e.g., molybdenum (Mo)) as a target.

19. The process for producing a CIS type thin-film solar cell according to claim 11 or 12, wherein the multilayered metallic back electrode layer comprises any one refractory metal selected from metals having resistance to selenium, such as molybdenum (Mo), titanium (Ti), and tantalum (Ta), or a combination thereof resulting from the formation of a compound (e.g., MoSiOₓ, etc.) with the silica layer.

20. The process for producing a CIS type thin-film solar cell according to claim 11 or 12, wherein a pressure regulation mechanism and/or an independent vacuum system is disposed between an alkali-free-layer deposition chamber for depositing the alkali-free layer and a metallic-back-electrode layer deposition chamber for depositing the metallic back electrode layer and the two thin layers are deposited in respective sputtering gas atmospheres (e.g., argon gas, Ar+O₂ mixture gas) differing in pressure and/or composition.
